# EUROPÄISCHE PATENTANMELDUNG

(11) **EP 0 657 945 A2**
(43) Veröffentlichungstag der Anmeldung: **14.06.1995**
(21) Anmeldenummer: 94118692.6
(22) Anmeldetag: 28.11.1994
(51) Int. Cl.: H01L 29/74

(54) **Schnelle Leistungshalbleiterbauelemente mit strukturierter Basis**

(30) Priorität: 13.12.1993 DE 4342482
(71) Anmelder: SIEMENS AKTIENGESELLSCHAFT, D-80333 München (DE)
(72) Erfinder: Brunner, Heinrich, Dr., D-81667 München (DE)

(57) **Zusammenfassung**

Der Anmeldungsgegenstand betrifft ein Leistungshalbleiter-bauelement, bei dem der Reihe nach eine anodenseitige Struktur (1), eine Basiszone (B) und eine kathodenseitige Struktur (2) vorgesehen sind,bei dem die Basiszone (B) aus einer Schicht (3) aus einem schwachdotierten n-leitenden Substratmaterial und mindestens einer weiteren Schicht (4,4') besteht, die sich hinsichtlich des Leitungstyps und/oder der Dotierungs-konzentration vom Substratmaterial unterscheidet und die zwischen der anodenseitigen Struktur (1) und der Schicht (3) aus dem Substratmaterial liegt.
Der mit dem Anmeldungsgegenstand erzielte Vorteil liegt inbesondere darin, daß während des Abschaltens kein dynamischer Lawinen-Durchbruch auftritt und daß ohne Änderung der Ladungsträgerlebensdauer und der Gesamtbasislänge ein möglichst schnelles Abklingen des Rückstromes (Tail-Stromes) gegeben ist.

## Beschreibung

Bei schnellen Dioden und Thyristoren ist unter anderem ein kleiner Spitzenwert des Rückstromes (reverse recovery current) von großer Bedeutung. Um den Spitzenwert des Rückstromes zu reduzieren kann beispielsweise die Emittereffizienz verringert werden.

Schnelle Dioden mit geringer Emittereffizienz sind aus dem IEEE-Paper zum 5th International Symposium on Power Semiconductor Devices and IC's, Seiten 199 - 204, mit dem Titel "Comparison of High Voltage Power Rectifier Structures" von M. Mehrotra et al. bekannt.

Um den Durchlaßwiderstand durch die niedrige Emittereffizienz nicht zu verschlechtern, wird die Ladungstragerlebensdauer dabei länger gewählt und bewirkt bei gleicher Gesamtbasislänge eine größere Speicherladung.

Die größere Speicherladung führt jedoch zu einer Vergrößerung und vor allem auch zu einer zeitlichen Verlängerung des Rückstromes (Tail-Stromes), wodurch, inbesondere bei hohen Abschaltspannungen, aufgrund der hohen Verlustleistung gegebenenfalls eine Zerstörung des Bauelementes eintreten kann.

Der Erfindung liegt nun die Aufgabe zugrunde, schnelle Leistungshalbleiterbauelemente anzugeben, bei denen während des Abschaltens auf eine hohe Batteriespannung kein dynamischer Lawinen-Durchbruch auftritt und bei denen ohne Änderung der Ladungsträgerlebensdauer und der Gesamtbasislänge ein möglichst schnelles Abklingen des Rückstromes (Tail-Stromes) gegeben ist.

Diese Aufgabe wird durch die Merkmale des Patentanspruchs 1 gelöst.

Neben der Verbesserung des Abschaltverhaltens ist als weiterer Vorteil die geringe Empfindlichkeit hinsichtlich Höhenstrahlung zu nennen, die zu Spontanausfällen führen kann. Die im geringere Empfindlichkeit wird dadurch bewirkt, daß bei der selben Durchbruchsspannung nur eine geringere maximale Feldstärke auftritt.

Die Ansprüche 2 bis 10 betreffen vorteilhafte Ausgestaltungen des erfindungsgemäßen Leistungshalbleiterbauelements.

Die Erfindung wird im folgenden anhand der Zeichnung näher erläutert. Dabei zeigt:
- Figur 1: den Aufbau einer erfindungsgemäßen Diode,
- Figur 2 und 3: jeweils eine vorteilhaftes Ausgestaltung der anodenseitigen Struktur der Diode nach Figur 1,
- Figur 4 und 5: jeweils eine vorteilhafte Ausgestaltung der kathodenseitigen Struktur der Diode nach Fig. 1,
- Figur 6: eine Ausgestaltung als erfindungsgemäßer Thyristor,
- Figur 7: eine Darstellung der elektrischen Feldstärke über die vertikale Ortskoordinate für ein bekanntes und ein erfindungsgemäßes Leistungshalbleiterbauelement zur Erläuterung der mit der Erfindung erzielten Vorteile und
- Figur 8: eine Darstellung des Rückstromes über der Zeit für ein bekanntes und erfindungsgemäßes Leistungshalbleiterbauelement.

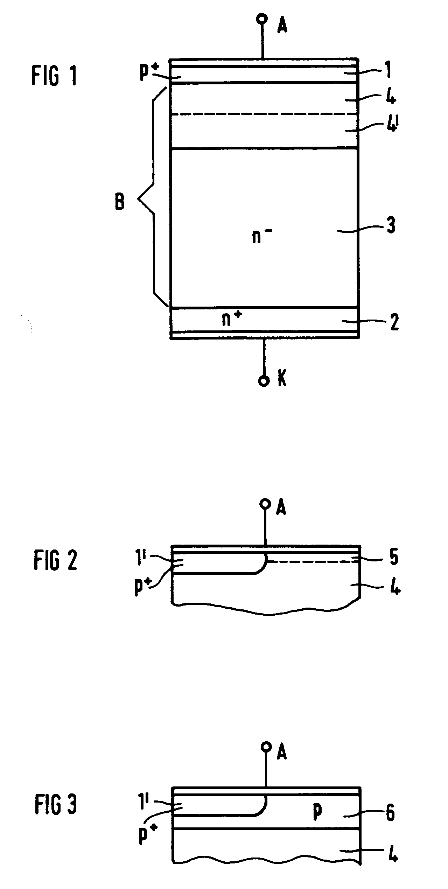

In Figur 1 ist ein Leistungshalbleiterbauelement gezeigt, bei dem in einem Halbleitergrundkörper der Reihe nach eine anodenseitige Struktur 1, eine Basiszone B und eine kathoden-seitige Struktur 2 vorgesehen sind.

Die anodenseitige Struktur besteht im Fall von Fig. 1 nur aus einem p⁺-dotierten Gebiet 1, das mit dem Anodenanschluß A elektrisch leitend verbunden ist und die kathodenseitige Struktur weist ein n⁺-dotierte Gebiet 2 auf, das mit dem Kathodenanschluß K elektrisch leitend verbunden ist. Das p⁺-dotierte Gebiet 1 weist eine Dicke von ≦ 30 µm und eine Dotierungskonzentration am anodenseitigen Rand von 10¹⁵ bis 10¹⁹ cm⁻³ auf. Das n⁺-dotierte ≦Gebiet 2 weist eine Dicke von ≦ 30 µm und eine Dotierungskonzentration am kathodenseitigen Rand von 10¹⁸ bis 10²⁰ cm⁻³ auf.

Die Basiszone B besteht der Reihe nach und anodenseitig beginnend aus einer ersten weiteren Schicht 4, einer optional vorgesehenen und gestrichelt angedeuteten, zweiten weiteren Schicht 4' und einer Schicht 3 aus einem n⁻-dotierten Substratmaterial. Die Dicke der Schicht 3 aus dem n⁻-dotierten Substratmaterial beträgt üblicherweise ungefähr 100 µm pro Kilovolt Sperrspannung und das Substratmaterial weist eine Grunddotierung von 8*10¹² bis 2*10¹⁴ cm⁻³ auf.

Dabei ist in einer ersten erfindungsgemäßen Ausgestaltung nur die erste weitere Schicht 4 der Basiszone vorgesehen und besteht aus einer zwischen 30 und 120 µm dicken p⁻-dotierten Schicht 4, die im Vergleich zu dem mindestens einen p⁺-dotierten Gebiet 1 der anodenseitigen Struktur schwächer, beispielsweise mit einer anodenseitigen Randkonzentration von 8*10¹² bis 2*10¹⁴ cm⁻³, dotiert ist. Eine typische Dicke der Schicht 4 beträgt 100 µm und eine typische Randkonzentration der Schicht 4 liegt bei 4*10¹³ cm⁻³.

Ferner ist in einer zweiten erfindungsgemäßen Ausgestaltung zusätzlich zur Schicht 4 der Basiszone eine zweite weitere Schicht 4' der Basiszone B vorgesehen, die aus einer im Vergleich zum n⁻-dotierten Substratmaterial schwächer, beispielsweise in der anodenseitigen Randkonzentration um den Faktor 0,1 schwächer, dotierten n⁻ ⁻-dotierten Schicht besteht. Die Gesamtdicke der beiden Schichten 4 und 4' entspricht dabei den obigen Angaben für die einzelne Schicht 4, wobei die Schichten 4 und 4' typischerweise ungefähr gleich dick sind.

Weiter ist in einer dritten erfindungsgemäßen Ausgestaltung lediglich die erste weitere Schicht 4 der Basiszone vorgesehen, die aus einer im Vergleich zum n⁻-dotierten Substratmaterial schwächer, beispielsweise um den Faktor 0,1 schwächer, dotierten n⁻ ⁻-dotierten Schicht besteht. Die Dicke der Schicht 4 liegt ebenfalls zwischen 30 und 120 µm und typischerweise bei 100 µm.

Die anodenseitige Struktur muß bei den obengenannten erfindungsgemäßen Ausgestaltungen nicht zwingend in Form einer ganzflächig vorgesehenen p⁺-dotierten Schicht (PiN-Diode) oder einer vergleichsweise dünnen p⁻-dotierten Schicht (P-iN-Diode) bestehen, sondern kann auch andere anodenseitige Strukturen zur Senkung der Emittereffizienz aufweisen, wie sie beispielsweise aus dem eingangs erwähnten Beitrag von M. Mehrotra et al. für sich bekannt sind.

Dabei ist z.B., wie in Figur 2 gezeigt, die anodenseitige Struktur so ausgebildet, daß auch die weitere Schicht 4 der Basiszone B, die an ein p⁺-dotiertes Gebiet 1' der anodenseitigen Struktur angrenzt, elektrisch leitend mit dem Anodenanschluß A verbunden sind (Merged P-i-N/Schottky Diode). Die Dicke und Randkonzentration des Gebietes 1' entspricht dabei dem Gebiet 1.

Ebenfalls in Fig. 2 sind zwei weitere anodenseitige Strukturen zur Senkung der Emittereffizienz gestrichelt dargestellt, die so ausgebildet sind, daß auch die weitere Schicht 4 der Basiszone B, die an das p⁺-dotierte Gebiet der anodenseitigen Struktur angrenzt, über ein Gebiet 5 mit dem Anodenanschluß A verbunden ist, das entweder aus einem im Vergleich zum p⁺-dotierem Gebiet 1' der anodenseitigen Struktur schwächer dotierten p⁻-dotierten Material (Static Shielding Diode) oder aus einer Metall/Silizium-Legierung (Soft and Fast recovery Diode) besteht.

In Figur 3 ist eine weitere anodenseitige Struktur zur Erhöhung der Emittereffizienz dargestellt, die so ausgebildet ist, daß sowohl das p⁺-dotierte Gebiet 1' der anodenseitigen Struktur als auch ein zusätzliches im Vergleich dazu niedriger dotiertes p-dotiertes Gebiet 6 der anodenseitigen Struktur elektrisch leitend mit dem Anodenanschluß A verbunden sind. Das zusätzliche p-dotierte Gebiet 6 ist dabei so angeordnet, daß das p⁺-dotierte Gebiet 1' der anodenseitigen Struktur und die an die anodenseitige Struktur angrenzende weitere Schicht 4 der Basiszone B von einander getrennt sind, wobei zusätzliche p-dotierte Gebiet 6 schwächer dotiert ist als das p⁺-dotierte Gebiet 1' der anodenseitigen Struktur.

Das in den Figuren 2 und 3 dargestellte zusammenhängende Gebiet 1' ist dabei auch in Form mehreren nicht unmittelbar zusammenhängenden Gebieten denkbar.

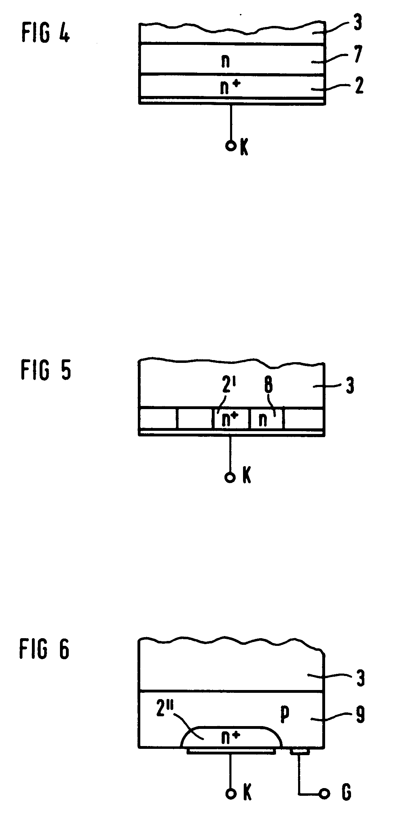

In Figur 4 ist eine Ausführungsform gezeigt, bei der die kathodenseitige Struktur eine im Vergleich zur n⁺-dotierten Schicht 2 der kathodenseitigen Struktur schwächer, beispielsweise 10¹⁴ bis 2*10¹⁴ cm⁻³, dotierte n-dotierte Pufferschicht 7 aufweist, die zwischen der Schicht 2 der kathodenseitigen Struktur und der Schicht 3 aus dem Substratmaterial liegt.

In Figur 5 ist eine weitere Ausführungsform dargestellt, bei der die katodenseitige Struktur mindestens ein n⁺-dotiertes Gebiet 2' und mindestens ein im Vergleich dazu schwächer, beispielsweise von der Grunddotierung bis 10¹⁴ cm⁻³, dotiertes n-dotiertes Gebiet 8 aufweist, wobei auch das mindestens eine schwächer dotierte Gebiet jeweils mit dem Kathodenanschluß K elektrisch leitend verbunden ist und an die Schicht 3 aus Substratmaterial direkt angrenzt.

Die in Figur 1 dargestellte erfindungsgemäß strukturierte Basiszone B und die in den Figuren 1,2 und 3 dargestellten verschiedenen anodenseitigen Strukturen sind sowohl für Dioden als auch für Thyristoren anwendbar.

In Figur 6 ist ein kathodenseitiger Teil eines entsprechenden Thyristors gezeigt. Ein zugehöriger anodenseitige Teil des Thyristors ist aus den Figuren 1,2 und 3 zu entnehmen. Der Thyristor unterscheidet sich von einer entsprechenden Diode lediglich dadurch, daß eine mit einem Gate-Anschluß G elektrisch leitend verbundene p-dotierte Gate-Schicht 9 zwischen der Schicht 3 aus dem Substratmaterial und mindestens einem n⁺-dotierten Gebiet 2'' der kathodenseitigen Struktur vorgesehen ist. Die Dicke und die Randkonzentration des Gebietes 2'' entsprechen dabei den Werten bei der Schicht 2.

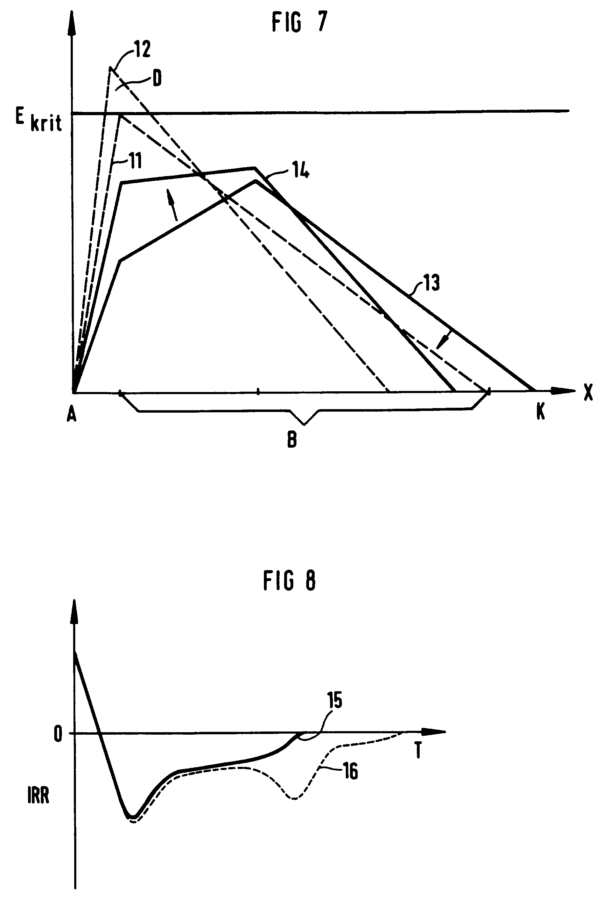

In Figur 7 sind Verläufe 11..14 von elektrischen Feldstärke über der Ortskoordinate x aufgetragen, wobei die x-Koordinate beim Anodenanschluß A beginnt und beim Kathodenanschluß K endet und wobei die Verläufe vereinfacht dargestellt sind. In das Diagramm ist ferner die kritische Durchbruchsfeldstärke Eₖᵣᵢₜ eingetragen, die für Silizium ca. 2*10⁵ V/cm beträgt.

Die Verläufe 11 und 12 entsprechen den Feldstärkeveläufen bei bekannten Leistungsdioden, wobei die Verläufe im wesentlichen dreieckförmig sind und wobei die Feldstärke jeweils unmittelbar am kathodenseitigen Ende der Schicht 1 liegt. Der Feldstärkeverlauf 11 gilt für den stationären Zustand und der Feld-stärkeverlauf 12 entspricht dem dynamischen Verlauf beim Abschalten. Hierbei fällt auf, daß beim Verlauf 12 der Feldstärkegradient vergrößert wird und eine höhere maximale Feldstärke auftritt als beim Verlauf 11.

Dieser dynamische Effekt entsteht dadurch, daß beim Übergang in den Sperrzustand Elektronen in Richtung Kathode und Löcher in Richtung Anode vom pn-Übergang abgesaugt werden. Die unkompensierten Donatorionen erzeugen eine Raumladungszone, deren Raumladung den Feldstärkegradient in der Raumladungszone bestimmt. Durch den Löchertransport durch die Raumladungszone wird die positive Raumladung erhöht und es vergrößert sich entsprechend der Feldgradient.

Wird, wie in Fig. 7, die maximale Feldstärke des Verlaufs 11, also für den stationären Fall der bekannten Diode, gleich der kritischen Durchbruchsfeldstärke Eₖᵣᵢₜ gewählt, so ist der Maximalwert des Verlaufes 12, also im dynamischen Fall der bekannten Diode, größer als die kritische Feldstärke und es kommt zu einem sogenannten dynamischen Lawinen-Durchbruch D, bei dem neue Ladungsträger durch Ladungsträgermultiplikation generiert werden.

Neben den Verläufen 11 und 12 sind auch die Verläufe 13 und 14 für eine erfindungsgemäße Diode dargestellt, wobei das Integral der Feldstärke zwischen den Grenzen A und K, d. h. die anglegte, in Sperrrichtung gepolte Spannung, bei allen vier Verläufen gleich ist. Der Maximalwert der elektrischen Feldstärke ist sowohl im Verlauf 13, also im stationären Fall, als auch im Verlauf 14, also dynamischen Fall, erheblich geringer als bei den Verlaufen 11 und 12. Der Grund hierfür ist, daß auf Grund der Schicht 4 und der gegebenenfalls vorhandenen Schicht 4' eine Feldabflachung durch Reduktion der Raumladung in diesem Bereich entsteht, die den durch den Löchertransport verursachten steileren Feldverlauf in der Schicht 3 kompensiert. Bei der Erfindung wird die maximale Feldstärke nicht mehr am kathodenseitigen Ende der Schicht 1, sondern am kathodenseitigen Ende der Schicht 4 oder gegebenenfalls der Schicht 4' erreicht.

Aus Fig. 7 ist erkennbar, daß sogar die angelegte, in Sperrrichtung gepolte Spannung noch erhöht werden könnte, ohne daß auch im dynamischen Fall die kritische Durchbruchseldstärke erreicht wird.

Figur 8 zeigt den zeitlichen Verlauf 15 des Rückstromes für eine erfindungsgemäße Diode und gestrichelt eingezeichnet den zeitlichen Verlauf 16 des Rückstromes für eine vergleichbare bekannte Diode beim Abschalten auf eine Sperrichtung gepolte Abschaltspannung. Dabei ist zu erkennen, daß auf Grund des dynamischen Lawinendurchbruchs D eine zweite Rückstromspitze entsteht und der Rückstrom länger verschieden von Null ist als beim Verlauf 15. Dies ist insbesondere bei hohen Abschalt-spannungen wegen der großen Verlustleistung von Nachteil. Ferner kann sich dadurch die zeitliche Änderung des Rückstroms abrupt ändern und bei eventuell vorhandenen induktiven Lasten zu unerwünschten Spannungspitzen führen.

Erfindungsgemäße Dioden lassen sich mit Vorteil als Freilaufdioden bei Motorsteuerungen oder Ähnlichem einsetzen und sind typischerweise für Nennsperrspannungen zwischen 1200 V und 4500 V ausgelegt.

Prinzipiell sind auch zu den obigen Leistungshalbleiter-bauelementen duale Bauelemente mit jeweils vertauschten Leitungstypen und vertauschten Anoden- und Kathodenanschlüssen denkbar.

## Patentansprüche

1. Leistungshalbleiterbauelement,
bei dem in einem Halbleitergrundkörper der Reihe nach eine anodenseitige Struktur (1,1',5,6), die einen Anodenanschluß (A) aufweist, eine Basiszone (B) und eine mit einem Kathodenanschluß elektrisch kontaktierte kathodenseitige Struktur (2,2',2'',7,8,9) vorgesehen sind,
bei dem die anodenseitige Struktur mindestens ein p-leitendes Gebiet (1,1') aufweist, das mit dem Anodenanschluß elektrisch leitend verbunden ist, und die kathodenseitige Struktur mindestens ein hochdotiertes n-leitendes Gebiet (2,2',2'') aufweist, das mit dem Kathodenanschluß elektrisch leitend verbunden ist,
und bei dem die Basiszone (B) aus einer Schicht (3) aus einem schwachdotierten n-leitenden Substratmaterial und mindestens einer weiteren Schicht (4,4') besteht, die sich hinsichtlich des Leitungstyps und/oder der Dotierungs-konzentration vom Substratmaterial unterscheidet und die zwischen der anodenseitigen Struktur und der Schicht aus dem Substrat-material liegt.

2. Leistungshalbleiterbauelement nach Anspruch 1,
bei dem eine der mindestens einen weiteren Schicht (4,4') der Basiszone aus einer p-leitenden Schicht (4) besteht, die im Vergleich zu dem mindestens einen p-leitenden Gebiet der anodenseitigen Struktur schwächer dotiert ist

3. Leistungshalbleiterbauelement nach Anspruch 2,
bei dem eine zweite der mindestens einen weiteren Schicht (4,4') der Basiszone (B) aus einer im Vergleich zum Substratmaterial schwächer dotierten n-leitenden Schicht (4') besteht, die zwischen der ersten weiteren Schicht (4) und der Schicht (3) aus dem Substratmaterial angeordnet ist.

4. Leistungshalbleiterbauelement nach Anspruch 1,
bei dem eine der mindestens einen weiteren Schicht (4,4') der Basiszone aus einer im Vergleich zum Substratmaterial schwächer dotierten n-leitenden Schicht (4) besteht.

5. Leistungshalbleiterbauelement nach einem der Ansprüche 1 bis 4,
bei dem eine mit einem Gate-Anschluß (G) elektrisch leitend verbundene p-dotierte Gate-Schicht (9) zwischen der Schicht (3) aus dem Substratmaterial und einer der mindestens einen hochdotierten n-leitenden Schicht (2'') der kathodenseitigen Struktur vorgesehen ist (Thyristor).

6. Leistungshalbleiterbauelement nach einem der Ansprüche 1 bis 4,
bei dem die kathodenseitige Struktur eine im Vergleich zur hochdotierten n-leitenden Schicht (2) der kathodenseitigen Struktur schwächer dotierte n-leitende Schicht (7) aufweist, die zwischen der n-leitenden Schicht (2) der kathodenseitigen Struktur und der Schicht (3) aus dem Substratmaterial liegt.

7. Leistungshalbleiterbauelement nach einem der Ansprüche 1 bis 4,
bei dem die katodenseitige Struktur das mindestens eine hochdotierte n-leitende Gebiet(2') und mindestens ein im Vergleich dazu schwächer dotiertes n-leitendes Gebiet (8) aufweist, wobei auch das mindestens eine schwächer dotierte Gebiet jeweils mit dem Kathodenanschluß (K) elektrisch leitend verbunden ist und an die Schicht (3) aus Substratmaterial direkt angrenzt.

8. Leistungshalbleiterbauelement nach einem der Ansprüche 1 bis 5,
bei dem die anodenseitige Struktur so ausgebildet ist, daß auch die mindestens eine weitere Schicht (4) der Basiszone (B), die an das p-leitende Gebiet der anodenseitigen Struktur angrenzt, elektrisch leitend mit dem Anodenanschluß (A) verbunden sind.

9. Leistungshalbleiterbaulement nach einem der Ansprüche 1 bis 5,
bei dem die anodenseitige Struktur so ausgebildet ist, daß auch die mindestens eine weitere Schicht (4) der Basiszone (B), die an das p-leitende Gebiet der anodenseitigen Struktur angrenzt, entweder über ein Gebiet (5) aus einem im Vergleich zum p-leitenden Gebiet (1') der anodenseitigen Struktur schwächer dotierten p-leitenden Material oder aus einer Metall/Silizium-Legierung mit dem Anodenanschluß (A) verbunden ist.

10. Leistungshalbleiterbauelement nach einem der Ansprüche 1 bis 5,
bei dem die anodenseitige Struktur so ausgebildet ist, daß sowohl das mindestens eine p-dotierte Gebiet (1') der anodenseitigen Struktur als auch ein zusätzliches p-dotiertes Gebiet (6) der anodenseitigen Struktur elektrisch leitend mit dem Anodenanschluß (A) verbunden sind,
daß durch das zusätzliche p-dotierte Gebiet (6) das mindestens eine p-leitende Gebiet(1') der anodenseitigen Struktur und die an die anodenseitige Struktur angrenzende weitere Schicht (4) der Basiszone (B) von einander getrennt sind,
und daß das zusätzliche p-leitende Gebiet (6) schwächer dotiert ist als das mindestens eine p-leitende Gebiet(1') der anodenseitigen Struktur.
